# EUROPEAN PATENT SPECIFICATION

(11) **EP 4 144 683 B1**
(45) Date of publication and mention of the grant of the patent: **18.03.2026**
(21) Application number: 21929794.2
(22) Date of filing: 14.07.2021
(51) Int. Cl.: G06F 30/12, G06F 30/17, B66C 13/16, G06F 30/20, B66C 13/46, B66C 23/88, B66C 15/06

(54) **DYNAMIC SIMULATION DISPLAY METHOD AND SYSTEM FOR WORKING MACHINE STRUCTURE**
DYNAMISCHES SIMULATIONSANZEIGEVERFAHREN UND SYSTEM FÜR EINE ARBEITSMASCHINENSTRUKTUR
PROCÉDÉ ET SYSTÈME D'AFFICHAGE DE SIMULATION DYNAMIQUE POUR STRUCTURE D'ENGIN DE TRAVAUX

(30) Priority: 09.03.2021 CN 202110258232
(43) Date of publication of application: 08.03.2023
(73) Proprietor: Zhejiang Sany Equipment Co., LTD, Huzhou, Zhejiang 313028 (CN)
(72) Inventor: HAN, Xiaodong, Huzhou, Zhejiang 313028 (CN); SUN, Hao, Huzhou, Zhejiang 313028 (CN); GUO, Song, Huzhou, Zhejiang 313028 (CN)
(74) Representative: Murgitroyd & Company
(86) International application number: PCT/CN2021/106255
(87) International publication number: WO 2022/188324

(56) References cited:
- WO-A2-2016/055025
- CN-A- 102 502 405
- CN-A- 104 192 714
- CN-A- 105 152 012
- CN-A- 108 715 410
- CN-A- 108 715 410
- CN-A- 109 970 009
- CN-A- 111 634 820
- CN-A- 111 634 820
- CN-A- 113 003 419
- JP-A- 2001 240 392
- JP-A- 2003 104 688
- US-A1- 2013 345 938

## Description

### TECHNICAL FIELD

The present disclosure relates to the field of automatic control technologies, in particular to a dynamic simulation display method and system for a working machine structure.

### BACKGROUND

With development of technologies, a lot of work is gradually transformed from manual to mechanical. A working machine may include a human-computer interface, through which working condition data of the working machine may be displayed to users.

At present, when the human-computer interface of the working machine is used to display the working condition data, it is usually displayed in a form of a static working condition diagram or non working condition diagram. When the working condition data of the working machine changes, the human-computer interface may only display a change of the working condition data, and may not display a corresponding change of the working machine intuitively, increasing a burden of information acquisition on users.

JP2003104688A discloses a method for dynamic simulation display of a working machine structure. The method comprises acquiring, in real time, working condition data of a working machine. The working condition data includes angle data of an operating arm, which further includes angle data of a lower arm of the operating arm. The method further comprises dynamically updating a currently displayed representation of the working machine structure based on the acquired working condition data. The angle data of the lower arm is obtained using an angle sensor disposed on the lower arm of the operating arm of the working machine.

CN111634820A discloses an automatic early warning system and method for a crane. The automatic early warning system includes a data acquisition module, a data storage module, a data analysis module and an information display module. The data acquisition module is used for acquiring operation data and image information of the crane; the data storage module is used for storing crane operation boundary data; the data analysis module is used for reading the current operation data of the crane and analyzing the difference value between the operation parameter and the operation boundary of the crane according to the operation data; and the information display module is used for reading and displaying the difference value between the operation parameter and the operation boundary of the crane and displaying graphs and/or numerical values which allow further operation to the operation boundary.

CN108715410A discloses an intelligent arm rising and falling control device and method for the tower condition of a crawler crane. The intelligent arm rising and falling control device includes a controller, a primary arm angle sensor, a secondary arm angle sensor, a primary arm tension sensor, a secondary arm tension sensor, a display, an operating handle, a safety protection part and a one-key arm rising/arm falling allowable switch as well as a primary variable-amplitude winch proportional valve, a secondary variable-amplitude winch proportional valve and a superlift variable-amplitude winch proportional valve. The controller is used for obtaining primary arm pull plate force information detected by the primary arm tension sensor, simultaneously obtaining secondary arm pull plate force information detected by the secondary arm tension sensor, getting the pull plate force information and sending the pull plate force information to the display to be displayed.

WO2016055025A2 discloses a crane operation range compensation method and apparatus. During the operation of a crane, obtaining the current operation range of the crane in real time, the operation of the crane including crane hook raising and lowering; determining whether the absolute value of the value difference between the current operation range of the crane and the operation range of the crane before the operation is less than a first threshold; if the absolute value of the value difference between the current operation range of the crane and the operation range of the crane before the operation is not less than the first threshold, determining the target range-changing angle value according to the operation range before the operation; adjusting the crane operation range according to the target range-changing angle value.

### SUMMARY

The present disclosure provides a dynamic simulation display method and system for a working machine structure to solve a defect in the prior art.

The present disclosure provides a dynamic simulation display method for a working machine structure, including:
acquiring working condition data of a working machine in real time, the working condition data including angle data of an operating arm, and the angle data of the operating arm including angle data of a lower arm and angle data of an upper arm;
updating a currently displayed working machine structure dynamically according to the working condition data and
comparing the angle data of the upper arm and the angle data of the lower arm to determine whether the operating arm is bent and deformed.

The angle data of the lower arm is obtained based on an angle sensor disposed on a lower arm of an operating arm of the working machine, and the angle data of the upper arm is obtained based on an angle sensor disposed on an upper arm of the operating arm of the working machine.

According to the dynamic simulation display method for the working machine structure provided by the present disclosure, the currently displayed working machine structure is obtained by combining assembly drawings of the working machine based on working condition data of the working machine obtained at a previous time; and the assembly drawings are generated based on a physical structure model of the working machine.

According to the dynamic simulation display method for the working machine structure provided by the present disclosure, the method further includes:
displaying the working condition data dynamically.

According to the dynamic simulation display method for the working machine structure provided by the present disclosure, the displaying the working condition data dynamically, specifically includes:
displaying the working condition data in a display area which is not the display area of the working machine structure; and/or,
marking the working condition data at a corresponding position of the working machine structure.

According to the dynamic simulation display method for the working machine structure provided by the present disclosure, after the updating a currently displayed working machine structure dynamically according to the working condition data, the method further includes:
if the currently displayed working machine structure is outside a working area, highlighting the working condition data.

According to the dynamic simulation display method for the working machine structure provided by the present disclosure, the working condition data further includes:
height data of a lifting hook of the working machine and distance data of an arm head from a lifting hook of the working machine to the operating arm. The height data of the lifting hook is determined based on a rope length extended by winch detected by a counting detection device provided on a winch of the working machine and a multiplying ratio, and the distance data of the arm head is determined based on the height data of the lifting hook.

According to the dynamic simulation display method for the working machine structure provided by the present disclosure, the operating arm includes a main arm and an auxiliary arm; and accordingly,
the working condition data further includes: angle data of operating arm corresponding to the main arm, angle data of operating arm corresponding to the auxiliary arm, and an included angle between the main arm and the auxiliary arm.

The present disclosure also provides a dynamic simulation display system for a working machine structure, including: a processor and angle sensors. The processor is connected to the angle sensors, the angle sensors are disposed on the lower arm of an operating arm of a working machine and an upper arm of the operating arm of the working machine; and
the processor is used for executing the dynamic simulation display method for the working machine structure described above.

According to the dynamic simulation display system for a working machine structure provided by the present disclosure, the dynamic simulation display system further includes: a counting detection device.

The counting detection device is disposed on a winch of the working machine, and the counting detection device is used for measuring a rope length extended by winch and a multiplying ratio.

The present disclosure provides a dynamic simulation display method and system for a working machine structure. In the method, the working condition data such as the angle data of the lower arm of the working machine in real time is acquired firstly, and then the currently displayed working machine structure according to the working condition data obtained is dynamically updated, which enables users to grasp a working condition change, a working state, and a relative position and other information of the working machine according to the updated displayed working machine structure intuitively. A burden of information acquisition on the users may be reduced and using experience of the working machine on the users may be improved.
intuitively. A burden of information acquisition on the users may be reduced and using experience of the working machine on the users may be improved.

### BRIEF DESCRIPTION OF THE DRAWINGS

In order to more clearly describe the technical solution in the present disclosure or in the prior art, accompanying drawings which will be used in description of embodiments or the prior art are briefly introduced below. Obviously, the accompanying drawings in the following description are some embodiments of the present disclosure. For those skilled in the art, other drawings may be obtained based on these drawings without paying creative labor.
FIG. 1 is a flowchart of a dynamic simulation display method for a working machine structure provided by the present disclosure.
FIG. 2 is a schematic diagram of a crane structure which is currently displayed according to a dynamic simulation display method for a working machine structure provided by the present disclosure.
FIG. 3 is a schematic diagram of a crane structure which is currently displayed after updating according to a dynamic simulation display method for a working machine structure provided by the present disclosure.
FIG. 4 is another schematic diagram of a crane structure which is currently displayed according to a dynamic simulation display method for a working machine structure provided by the present disclosure.
FIG. 5 is another schematic diagram of a crane structure which is currently displayed after updating according to a dynamic simulation display method for a working machine structure provided by the present disclosure.
FIG. 6 is a structural schematic diagram of a dynamic simulation display device for a working machine structure provided by the present disclosure.
FIG. 7 is a structural schematic diagram of a dynamic simulation display system for a working machine structure provided by the present disclosure.
FIG. 8 is a structural schematic diagram of an electronic device provided by the present disclosure.

Reference:
1: crane body; 2: main arm; 22: lower arm;
23: middle arm; 24: upper arm; 3: auxiliary arm.

### DETAILED DESCRIPTION OF THE EMBODIMENTS

In order to make the purpose, technical solution and advantages of the present disclosure clearer, the technical solution in the present disclosure will be described clearly and completely below with reference to the accompanying drawings in the present disclosure. Obviously, the described embodiments are part of the embodiments of the present disclosure, not all of them. Based on the embodiments in the present disclosure, all other embodiments obtained by those skilled in the art without doing creative work fall in the scope of protection in the present disclosure.

A human-computer interface of a working machine in the prior art usually displays a static working condition diagram or does not display a working condition diagram. Therefore, when an actual working condition of the working machine changes, users may not intuitively obtain a working condition change of the working machine from the human-computer interface in time, increasing a burden of information acquisition on users. For this reason, embodiments of the present disclosure provide a dynamic simulation display method for a working machine structure.

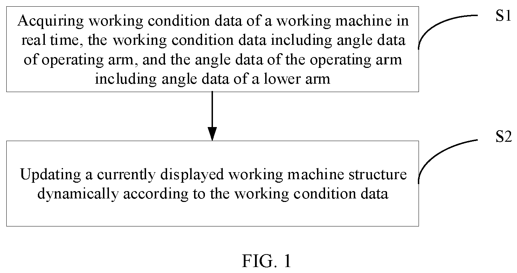

FIG. 1 is a flowchart of the dynamic simulation display method for the working machine structure provided by the present disclosure. As shown in FIG. 1, the method includes:
S1, acquiring working condition data of a working machine in real time, the working condition data including angle data of operating arm, and the angle data of the operating arm including angle data of a lower arm;
S2, updating a currently displayed working machine structure dynamically according to the working condition data.

The angle data of the lower arm is obtained based on an angle sensor disposed on a lower arm of an operating arm of the working machine.

Specifically, according to the dynamic simulation display method for the working machine structure provided by an embodiment of the present disclosure, an executive body of the method may be a dynamic simulation display device for a working machine structure, which has both data processing and display functions. That is to say, the dynamic simulation display device for a working machine structure may include a processor and a display screen. The data processing function is realized through the processor, and the display function is realized through the display screen.

The dynamic simulation display device for the working machine structure may be a human-computer interface of the working machine, and may also be configured in a remote control device. The embodiment of the present disclosure aims to dynamically display the working machine structure through the dynamic simulation display device for the working machine structure, that is, when the working condition data of the working machine changes, the working machine structure displayed may be dynamically updated, so that users may grasp a working status of the working machine more intuitively and timely.

Firstly, step S1 is executed to acquire the working condition data of the working machine in real time, that is, to acquire the working condition data of the working machine at a current time. The working condition data refers to data representing status of each component of the working machine. The working machine may be a working machine with an operating arm, such as a crane, a concrete pump truck, and etc. The working condition data may include angle data of operating arm. The angle data of the operating arm refers to angle data of operating arm of the working machine. The angle data of the operating arm refers to an included angle between a central axis of the operating arm and a horizontal plane. The operating arm of the working machine is a arm structure of the working machine, which includes an upper arm and a lower arm. Therefore, the angle data of the operating arm may at least include the angle data of the lower arm. In addition, the working condition data may also include a length, a working radius, a working height, a minimum working radius, a maximum working radius and other data of the operating arm, which are not specifically limited in the embodiments of the present disclosure.

According to the invention, an angle sensor is disposed on the lower arm of the working machine, and the angle data of the lower arm is obtained through the angle sensor. The angle data of the lower arm is a specific angle value, while data obtained by the angle sensor is usually angle signals of the lower arm, which are analog electrical signals. Therefore, the angle sensor disposed on the lower arm may be connected to a controller of the working machine, and the controller of the working machine my be connected to the dynamic simulation display device for the working machine structure. A working state of the angle sensor disposed on the lower arm may be controlled by the controller of the working machine, and the angle signals measured by the angle sensor disposed on the lower arm may be converted into the angle data of the lower arm, that is, the angle signals of the lower arm is converted to the angle data of the lower arm by the controller of the working machine. Then, through the controller of the working machine, the angle data of the lower arm is sent to the dynamic simulation display device for the working machine structure, so that the dynamic simulation display device for the working machine structure may execute step S2.

Then step S2 is executed. The currently displayed working machine structure refers to a working machine structure displayed on the display screen of the dynamic simulation display device for the working machine structure corresponding to working condition data at a previous time. The working machine structure may be obtained by combining assembly drawings. The working condition data of the working machine obtained in step S1 may be used to dynamically update the currently displayed working machine structure, and specifically, a operating arm structure of the working machine structure may be updated. The updated working machine structure corresponds to the working condition data of the working machine at the current time.

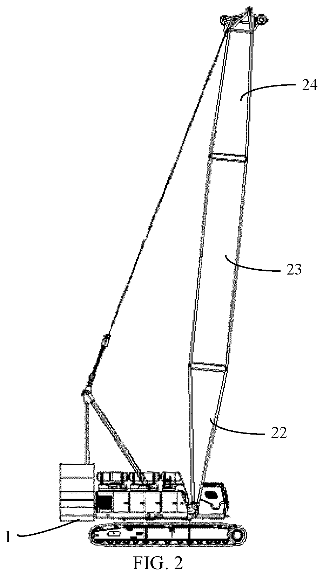

For example, the working machine is a crane. As shown in FIG. 2, FIG. 2 is a schematic diagram of a crane structure currently displayed. It can be seen from FIG. 2 that the crane includes a crane body 1, an operating arm, a mast and a lifting hook. The operating arm may include a lower arm 22, a middle arm 23 and an upper arm 24. An angle sensor may be disposed on the lower arm 22 (the angle sensor and its setting position are not shown in FIG. 2, and the setting position of the angle sensor on the lower arm is not specifically defined in the embodiment of the present disclosure). The angle data of the lower arm may be measured by the angle sensor. Then, the angle data of the lower arm is displayed on the crane structure, that is, the angle data may be shown by the crane structure displayed.

According to the dynamic simulation display method for the working machine structure provided by the embodiment of the present disclosure, the working condition data such as the angle data of the lower arm of the working machine in real time is acquired firstly, and then the currently displayed working machine structure according to the working condition data obtained is dynamically updated, which enables users to grasp a working condition change, a working state, and a relative position and other information of the working machine according to the updated displayed working machine structure intuitively. A burden of information acquisition on the users may be reduced and using experience of the working machine on the users may be improved.

On the basis of the above embodiments, according to the dynamic simulation display method for the working machine structure provided by embodiments of the present disclosure, the angle data of the operating arm further includes angle data of an upper arm.

The angle data of the upper arm is obtained based on an angle sensor disposed on the upper arm of the operating arm of the working machine.

Specifically, the angle data of the operating arm according to the invention, does also include the angle data of the upper arm, which is measured by the angle sensor disposed on the upper arm of the working machine. The angle data of the upper arm is a specific angle value, while data obtained by the angle sensor is usually angle signals of the upper arm, which are analog electrical signals. Therefore, the angle sensor disposed on the upper arm may be connected to the controller of the working machine, and the controller of the working machine may be connected to the dynamic simulation display device for the working machine structure. A working state of the angle sensor disposed on the upper arm is controlled by the controller of the working machine, and the angle signals measured by the angle sensor disposed on the upper arm may be converted into the angle data of the upper arm, that is, the angle signals of the upper arm is converted to the angle data of the upper arm by the controller of the working machine. Then, through the controller of the working machine, the angle data of the upper arm and the angle data of the lower arm are sent to the dynamic simulation display device for the working machine structure, so that the dynamic simulation display device for the working machine structure may execute step S2. That is to say, the angle data of the upper arm and the angle data of the lower arm are both displayed on the crane structure together.

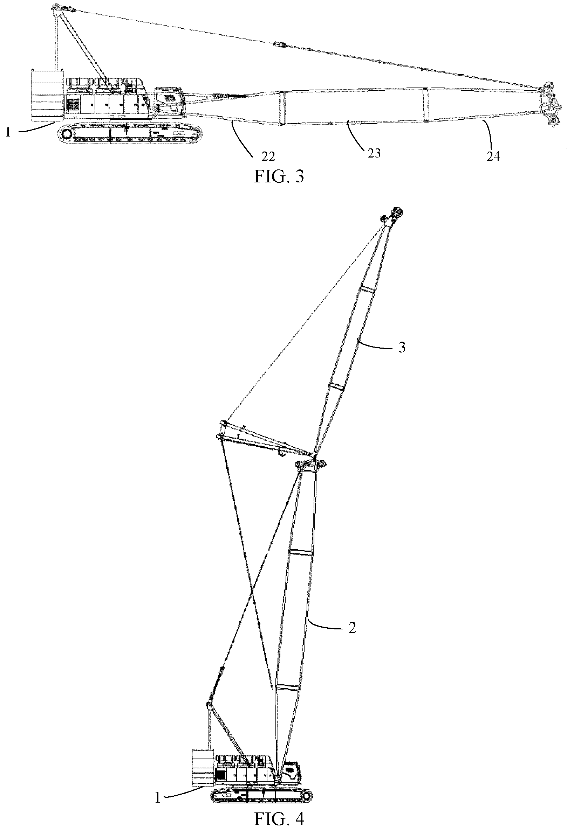

As for the crane structure shown in FIG. 2, if the angle data of the upper arm and the angle data of the lower arm are both 80 degrees, that is, the upper arm 24 and the lower arm 22 are on a same straight line, and both are at an included angle of 80 degrees with a horizontal plane. If both the angle data of the upper arm and the angle data of the lower arm of the crane at the current time obtained through step S1 are 0 degree, the crane structure shown in FIG. 2 transforms into a structure shown in FIG. 3. In addition, if the angle data of the lower arm of the crane at the current moment obtained through step S2 is 80 degrees and the angle data of the upper arm of the crane at the current moment obtained through step S2 is 70 degrees, it means that the crane arm structure has been bent and deformed during a time interval from a previous moment to the current moment, resulting in an included angle of 10 degrees between the lower arm and the upper arm. This information may all be displayed by the crane structure displayed.

According to the invention, the introduction of the angle data of the upper arm may realize a dynamic update of the currently displayed working machine structure when the working condition data changes, which enable the users to grasp the working condition change, the working state, the relative position and other information of the working machine according to the updated displayed working machine structure intuitively, which reduces a burden of information acquisition on the users, and improves using experience of the working machine on the users. By comparing the angle data of the upper arm and the angle data of the lower arm, whether the crane arm structure is bent and deformed is determined, which may improve safety of the working machine.

On the basis of the above embodiments, according to the dynamic simulation display method for the working machine structure provided by an embodiment of the present disclosure, the currently displayed working machine structure is obtained by combining assembly drawings of the working machine according to the working condition data of the working machine obtained at a previous time. The assembly drawings are generated based on a physical structure model of the working machine.

Specifically, in an embodiment of the present disclosure, the assembly drawings of the working machine may be generated through the physical structure model of the working machine, that is, by decomposing the physical structure model of the working machine to obtain images representing the crane body, the arm structure, the mast, and the lifting hook and other components, which are the assembly drawings. Then, combined with the working condition data of the working machine obtained at a previous time, the assembly drawings are connected and combined through an image processing technology to form the currently displayed working machine structure, namely, a working condition diagram currently displayed. The currently displayed working machine structure is consistent with an actual working condition of the working machine, so as to show the user an accurate working state of the working machine. The assembly drawings of the working machine may be generated by a third-party equipment, and loaded to the dynamic simulation display device for the working machine structure through a program, or directly generated by the dynamic simulation display device for the working machine structure, which is not specifically limited in the embodiments of the present disclosure.

According to the embodiment of the present disclosure, a method for determining a currently displayed working machine structure is provided, which may enable the dynamic simulation display method for the working machine structure to be carried out successfully.

On the basis of the above embodiments, according to the dynamic simulation display method for the working machine structure provided in the embodiments of the present disclosure, after the acquiring working condition data of a working machine in real time, the method, the method further includes:
displaying the working condition data dynamically.

Specifically, in an embodiment of the present disclosure, after step S1 is executed, the obtained working condition data may also be dynamically displayed directly, that is, the working condition data may be displayed at a fixed position of the display screen while the working machine structure is displayed, and the working condition data which is currently displayed may be updated by using the working condition data obtained at the current time.

According to the embodiment of the present disclosure, the working machine structure and the working condition data of the working machine are displayed dynamically at the same time, so that the user may more comprehensively grasp relevant information of the working machine from dimensions of data, structure, and etc.

On the basis of the above embodiments, according to the dynamic simulation display method for the working machine structure provided by the embodiments of the present disclosure, the displaying the working condition data dynamically, specifically includes:
displaying the working condition data in a display area which is not the display area of the working machine structure; and/or,
marking the working condition data at a corresponding position of the working machine structure.

Specifically, in an embodiment of the present disclosure, when the working condition data is dynamically displayed, it can be displayed in the display area which is not the display area of the working machine structure. The display area for the working machine structure refers to an area used to display the working machine structure on the display screen. The display area which is not the display area of the working machine structure refers to am area on the display screen apart from the display area for the working machine structure. In this way, the working machine structure and the working condition data may be displayed separately to avoid mutual influence between the two display areas. Since there are multiple types of working condition data, each working condition data may be displayed at a corresponding fixed position, so that users may quickly find the working condition data they are concerned about. The working condition data may also be marked on the corresponding position of the working machine structure. For example, for the angle data of the lower arm, a connection point between the crane body and the lower arm may be used as an origin to represent the angle data of the lower arm between the lower arm and the horizontal plane; for the angle data of the upper arm, a connection point between the upper arm and the middle arm may be used as an origin to represent the angle data of the upper arm; for distance data of an arm head of the operating arm, the ground may be taken as a reference plane, and a marking line may be drawn between the head of the operating arm and the ground, and specific distance data of an arm head may be written at one side of the marking line. In this way, users may move their eyes a short distance to grasp detailed information.

In the embodiment of the present disclosure, three different dynamic display modes of the working condition data are provided, so that the display of the working condition data may be more flexible.

On the basis of the above embodiments, according to the dynamic simulation display method for the working machine structure provided in the embodiments of the present disclosure, after the updating a currently displayed working machine structure dynamically according to the working condition data, the method further includes:
if the currently displayed working machine structure is outside a working area, highlighting the working condition data.

Specifically, in the embodiment of the present disclosure, a working area may be set for the working machine structure on the display screen. After the currently displayed working machine structure is dynamically updated, the currently displayed working machine structure changes into an updated working machine structure. If the currently displayed working machine structure is outside the working area, the working condition data may be highlighted, for example, the angle data and working radius may be displayed in red or highlighted color to remind the user to pay attention to safety.

According to the embodiment of the present disclosure, when the working machine structure is outside the working area, the user may be prompted to pay attention to safety by highlighting the working condition data, which may improve usage safety of the working machine.

On the basis of the above embodiments, according to the dynamic simulation display method for the working machine structure provided by the embodiments of the present disclosure, the working condition data further includes: height data of a lifting hook of the working machine and distance data of an arm head from a lifting hook of the working machine to the operating arm. The height data of the lifting hook is determined based on a rope length extended by winch detected by a counting detection device provided on a winch of the working machine and a multiplying ratio, and the distance data of the arm head is determined based on the height data of the lifting hook.

Specifically, in the embodiment of the present disclosure, the working condition data may also include the height data of the lifting hook and the distance data of the arm head of the working machine. The height data of the lifting hook refers to a distance between the lifting hook of the working machine and the ground, and the distance data of the arm head refers to a distance between the arm head and the lifting hook of the working machine. Since the distance between the arm head of the working machine and the ground may be calculated by summing up the length of the operating arm and a height of a body of the working machine, which is also equal to a sum of the height data of the lifting hook and the distance data of the arm head. The height data of the lifting hook may be determined first, and then the distance data of the arm head may be determined by a difference between the distance between the arm head of working machine and the ground and the height data of the lifting hook. In the process of determining the height data of the lifting hook, a counting detection device may be disposed on the winch of the working machine. The rope length extended by winch and the multiplying ratio may be measured by the counting detection device to determine the height data of the lifting hook. Furthermore, according to the height data of the lifting hook, the distance data of the arm head of the working machine and other working condition data, the currently displayed working machine structure may be dynamically updated, and the height data of the lifting hook, the distance data of the arm head of the working machine and other working condition data may be dynamically displayed.

The rope length extended by winch and the multiplying ratio are specific values, while data measured by the counting detection device is usually analog electrical signals. Therefore, the counting detection device may be connected to the controller of the working machine, and the controller of the working machine may be connected to the dynamic simulation display device for the working machine structure. The working state of the counting detection device is controlled by the controller of the working machine, and the analog electrical signals measured by the counting detection device may be converted into specific values of the rope length extended by winch and the multiplying ratio. Then, through the controller of the working machine, the specific values of the rope length extended by winch and the multiplying ratio are sent to the dynamic simulation display device for a working machine structure, so that the dynamic simulation display device for the working machine structure may process the data subsequently.

In the embodiment of the present disclosure, the specific content of the working condition data is enriched, which may make the displayed content more comprehensive.

On the basis of the above embodiments, according to the dynamic simulation display method for the working machine structure provided by the embodiments of the present disclosure, the operating arm includes a main arm and an auxiliary arm; and accordingly,
the working condition data further includes: angle data of operating arm corresponding to the main arm, angle data of operating arm corresponding to the auxiliary arm, and an included angle between the main arm and the auxiliary arm.

Specifically, as shown in FIG. 4, a crane is taken as an example to be the working machine in the embodiment of the present disclosure. The operating arm may include a main arm 2 and an auxiliary arm 3. The main arm 2 is connected to the crane body 1, and the auxiliary arm 3 is connected to the main arm 2. Both the main arm 2 and the auxiliary arm 3 contain a lower arm, a middle arm and an upper arm, and angle sensors are disposed on each lower arm and each upper arm, that is, the angle data of the operating arm corresponding to the main arm may include angle data of an upper arm and angle data of a lower arm of the main arm, and the angle data of the operating arm corresponding to the auxiliary arm may include angle data of an upper arm and angle data of a lower arm of the auxiliary arm. When there is no bending deformation of the main arm and auxiliary arm, that is, when the angle data of the upper arm and the angle data of the lower arm of the main arm are equal, and the angle data of the upper arm and the angle data of the lower arm of the auxiliary arm are equal, the included angle between the main arm and the auxiliary arm may be an included angle between the central axis of the main arm and the central axis of the auxiliary arm. When the main arm and/or the auxiliary arm have bending deformation, the included angle between the main arm and auxiliary arm may be an included angle between the upper arm of the main arm and the lower arm of the auxiliary arm. Furthermore, according to the angle data of the operating arm corresponding to the main arm, the angle data of the operating arm corresponding to the auxiliary arm, and the included angle between the main arm and the auxiliary arm and other working condition data, the currently displayed working mechanical structure may be dynamically updated, and the angle data of the operating arm corresponding to the main arm, the angle data of the operating arm corresponding to the auxiliary arm, the included angle between the main arm and the auxiliary arm and other working condition data may be dynamically displayed.

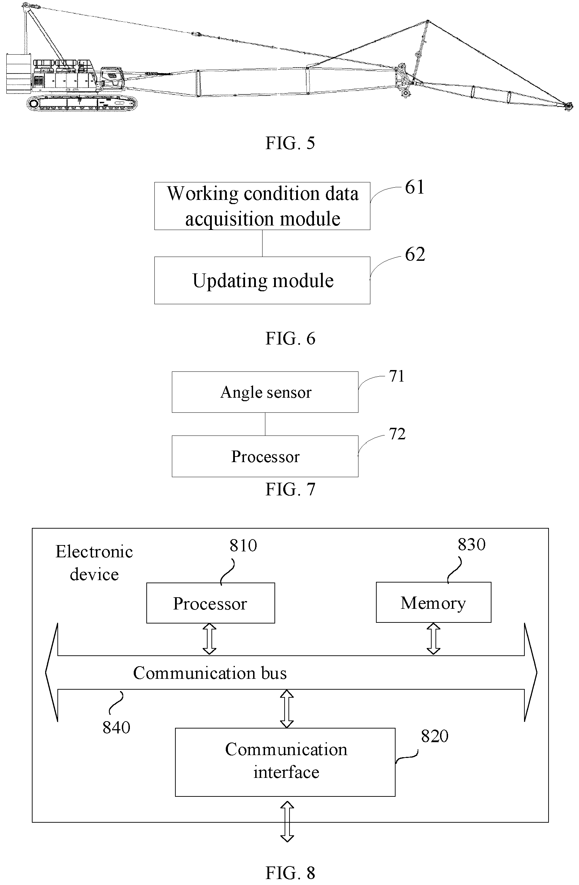

If the main arm and auxiliary arm are not bent and deformed, in the crane structure shown in FIG. 4, the angle data of the upper arm of the main arm and the angle data of the lower arm of the main arm are both 65 degrees, that is, the upper arm of the main arm and the lower arm of the main arm are on the same straight line, and both are at an included angle of 65 degrees with the horizontal plane. The angle data of the upper arm of the auxiliary arm and the angle data of the lower arm of the auxiliary arm are both 55 degrees, that is, the upper arm of the auxiliary arm and the lower arm of the auxiliary arm are on the same straight line, and both are at an included angle of 55 degrees with the horizontal plane. The included angle between the main arm and the auxiliary arm is 10 degrees. If the angle data of the upper arm and the angle data of the lower arm of the main arm of the crane at the current moment obtained through step S1 are both 0 degree, and the angle data of the upper arm and the angle data of the lower arm of the auxiliary arm are both -10 degrees, the crane structure shown in FIG. 4 transforms into a structure shown in FIG. 5.

As shown in FIG. 6, on the basis of the above embodiments, the embodiment of the present disclosure provides a dynamic simulation display device for working machine structure, including: a working condition data acquisition module 61 and an updating module 62.

The working condition data acquisition module 61 is used for acquiring working condition data of a working machine in real time. The working condition data includes angle data of operating arm, and the angle data of the operating arm includes angle data of a lower arm.

The updating module 62 is used for updating a currently displayed working machine structure dynamically according to the working condition data.

The angle data of the lower arm is obtained based on an angle sensor disposed on a lower arm of an operating arm of the working machine.

On the basis of the above embodiments, according to the dynamic simulation display device for a working machine structure provided by the embodiments of the present disclosure, the angle data of the operating arm also includes angle data of an upper arm.

The angle data of the upper arm is obtained based on an angle sensor disposed on an upper arm of the operating arm of the working machine.

On the basis of the above embodiments, according to the dynamic simulation display device for a working machine structure provided by the embodiments of the present disclosure, the currently displayed working machine structure is obtained by combining assembly drawings of the working machine based on working condition data of the working machine obtained at a previous time; and the assembly drawings are generated based on a physical structure model of the working machine.

On the basis of the above embodiments, according to the dynamic simulation display device for a working machine structure provided by the embodiments of the present disclosure, the device further includes:
a display module, used for displaying the working condition data dynamically.

On the basis of the above embodiments, according to the dynamic simulation display device for a working machine structure provided by an embodiment of the present disclosure, the display module is specifically used for:
displaying the working condition data in a display area which is not the display area of the working machine structure; and/or,
marking the working condition data at a corresponding position of the working machine structure.

On the basis of the above embodiments, according to the dynamic simulation display device for a working machine structure provided by an embodiment of the present disclosure, the display module is also used for:
if the currently displayed working machine structure is outside a working area, highlighting the working condition data.

On the basis of the above embodiments, according to the dynamic simulation display device for a working machine structure provided by an embodiment of the present disclosure, the working condition data further includes: height data of a lifting hook of the working machine and distance data of an arm head from a lifting hook of the working machine to the operating arm. The height data of the lifting hook is determined based on a rope length extended by winch detected by a counting detection device provided on a winch of the working machine and a multiplying ratio, and the distance data of the arm head is determined based on the height data of the lifting hook.

On the basis of the above embodiments, according to the dynamic simulation display device for a working machine structure provided by an embodiment of the present disclosure, the operating arm includes a main arm and an auxiliary arm; and accordingly,
the working condition data further includes: angle data of operating arm corresponding to the main arm, angle data of operating arm corresponding to the auxiliary arm, and an included angle between the main arm and the auxiliary arm.

Specifically, for the dynamic simulation display device for a working machine structure provided in the embodiment of the present disclosure, a role of each module corresponds to an operation process of each step in the above embodiment of methods one-to-one, and the effect achieved is also consistent, which will not be described in the embodiment of the present disclosure here.

As shown in FIG. 7, on the basis of the above embodiments, an embodiment of the present disclosure provides a dynamic simulation display system for a working machine structure, including: a processor 71 and an angle sensor 72. The processor 71 is connected to the angle sensor 72, and the angle sensor 71 is disposed on a lower arm of an operating arm of a working machine. The processor is used for executing the dynamic simulation display method for the working machine structure according to the above method embodiments, for example: acquiring working condition data of a working machine in real time, the working condition data including angle data of operating arm, and the angle data of the operating arm including angle data of a lower arm; updating a currently displayed working machine structure dynamically according to the working condition data. The angle data of the lower arm is obtained based on an angle sensor disposed on a lower arm of an operating arm of the working machine.

Specifically, in the embodiment of the present disclosure, data measured by the angle sensor is usually angle signals of the lower arm, which are analog electrical signals. Therefore, the angle sensor may be connected to the controller of the working machine, and the controller of the working machine may be connected to the processor. A working state of the angle sensor is controlled by the controller of the working machine, and the angle signals measured by the angle sensor may be converted into the angle data of the lower arm, that is, the angle signals of the lower arm are converted to the angle data of the lower arm by the controller of the working machine. Finally, according to the working condition data of the working machine obtained in real time, the processor may dynamically update the currently displayed working machine structure. Here, a function of the processor is exactly the same as that of the dynamic simulation display device for a working machine structure provided in the above device embodiments, so it will not be repeated here.

The dynamic simulation display system for a working machine structure provided in the embodiment of the present disclosure may obtain, by setting the processor and the angle sensor, the working condition data such as the angle data of the lower arm of the working machine in real time, and dynamically update, by setting the processor and the angle sensor, the currently displayed working machine structure according to the working condition data obtained, which enables users to grasp a working condition change, a working state, a relative position and other information of the working machine according to the updated displayed working machine structure intuitively. A burden of information acquisition on the users may be reduced, and using experience of the working machine on the users may be improved.

On the basis of the above embodiments, an embodiment of the present disclosure provides a dynamic simulation display system for a working machine structure, further also including: a counting detection device.

The counting detection device is disposed on a winch of the working machine, and the counting detection device is used for measuring a rope length extended by winch and a multiplying ratio.

Specifically, in the embodiment of the present disclosure, data measured by the counting detection device is usually analog electrical signals. Therefore, the counting detection device may be connected to the controller of the working machine, and the controller of the working machine may be connected to the processor. A working state of the counting detection device is controlled by the controller of the working machine, and the analog electrical signals measured by the counting detection device may be converted into specific values of the rope length extended by winch and the multiplying ratio. Then, through the controller of the working machine, the specific values of the rope length extended by winch and the multiplying ratio are sent to the processor for subsequent processing.

FIG. 8 illustrates a physical structure schematic diagram of an electronic device. As shown in FIG. 8, the electronic device includes: a processor 810, a communication interface 820, a memory 830, and a communication bus 840. The processor 810, the communication interface 820 and the memory 830 realize communication to each other through the communication bus 840. The processor 810 may call logic instructions in the memory 830 to execute the dynamic simulation display method for the working machine structure provided in the above embodiments. The method includes: acquiring working condition data of a working machine in real time, the working condition data including angle data of operating arm, and the angle data of the operating arm including angle data of a lower arm; updating a currently displayed working machine structure dynamically according to the working condition data. The angle data of the lower arm is obtained based on an angle sensor disposed on a lower arm of an operating arm of the working machine.

In addition, the logic instructions in the memory 830 described above may be realized in a form of a software functional unit, and may be stored in a computer readable storage medium when sold or used as an independent product. Based on this understanding, the technical solution of the present disclosure in essence or a part that contributes to the prior art or a part of the technical solution, may be embodied in the form of a software product, which is stored in a storage medium, including a number of instructions to enable a computer device (which may be a personal computer, a server, or a network device, etc.) to perform all or part of the steps of the method described in various embodiments of the present disclosure. The aforementioned storage medium includes: a USB flash disk, a mobile hard disk, a read only memory (ROM), a random access memory (RAM), a magnetic disc or an optical disc and other mediums that may store program codes.

On the other hand, the present disclosure also provides a computer program product. The computer program product includes a computer program stored on a non-transitory computer-readable storage medium. The computer program includes program instructions. When the program instructions are executed by a computer, the computer may execute the dynamic simulation display method for the working machine structure provided in the above embodiments. The method includes: acquiring working condition data of the working machine in real time, the working condition data including angle data of operating arm, and the angle data of the operating arm including angle data of a lower arm; according to the working condition data, updating the currently displayed working machine structure dynamically; therein the angle data of the lower arm is measured based on an angle sensor of the lower arm of the operating arm of the working machine.

On the other hand, the present disclosure also provides a non-transitory computer readable storage medium, on which a computer program is stored. When the computer program is executed by the processor, it is implemented to execute the dynamic simulation display method for the working machine structure provided in the above embodiments. The method includes: acquiring working condition data of a working machine in real time, the working condition data including angle data of operating arm, and the angle data of the operating arm including angle data of a lower arm; updating a currently displayed working machine structure dynamically according to the working condition data. The angle data of the lower arm is obtained based on an angle sensor disposed on a lower arm of an operating arm of the working machine.

The device embodiments described above are only schematic, in which units described as separate components may be or may not be physically separated, and components displayed as units may be or may not be physical units, that is, they may be located in one place, or they may be distributed to multiple network units. Some or all of the modules may be selected according to actual needs to achieve a purpose of the embodiment. Those skilled in the art may understand and implement the embodiments without paying creative labor.

Through the above description of the embodiments, those skilled in the art may clearly understand that each embodiment may be implemented through software with necessary general hardware platform, and of course, by means of hardware. Based on this understanding, the above technical solution in essence or a part that contributes to the prior art may be embodied in a form of a software product, which may be stored in a computer readable storage medium, such as a ROM, a RAM, a magnetic disc, an optical disc, etc, A number of instructions are included to enable a computer device (which may be a personal computer, a server, or a network device, etc.) to execute the methods described in each embodiment or some parts of the embodiments.

Finally, it should be noted that the above embodiments are only used to illustrate the technical solution of the present invention and are not intended to limit its scope; Modifications, substitutions, and variations to the described embodiments may be made by a person skilled in the art without departing from the scope of the invention as defined by the claims. Such modifications or equivalents shall be considered to fall within the scope of protection as defined by the appended claims.

## Claims

1. A dynamic simulation display method for a working machine structure, comprising:
acquiring (S1) working condition data of a working machine in real time, the working condition data comprising angle data of an operating arm, and the angle data of the operating arm comprising angle data of a lower arm (22) and angle data of an upper arm (24);
updating (S2) a currently displayed working machine structure dynamically according to the working condition data; and
comparing the angle data of the upper arm (24) and the angle data of the lower arm (22) to determine whether the operating arm is bent and deformed;
wherein the angle data of the lower arm (22) is obtained based on an angle sensor disposed on a lower arm (22) of an operating arm of the working machine, and the angle data of the upper arm (24) is obtained based on an angle sensor disposed on an upper arm (24) of the operating arm of the working machine.

2. The dynamic simulation display method for the working machine structure according to claim 1, wherein the currently displayed working machine structure is obtained by combining assembly drawings of the working machine based on working condition data of the working machine obtained at a previous time; and the assembly drawings are generated based on a physical structure model of the working machine.

3. The dynamic simulation display method for the working machine structure according to claim 1, after the acquiring working condition data of a working machine in real time, the method, further comprising:
displaying the working condition data dynamically.

4. The dynamic simulation display method for the working machine structure according to claim 3, wherein the displaying the working condition data dynamically specifically comprises:
displaying the working condition data in a display area which is not the display area of the working machine structure; and/or,
marking the working condition data at a corresponding position of the working machine structure.

5. The dynamic simulation display method for the working machine structure according to claim 3, after the updating a currently displayed working machine structure dynamically according to the working condition data, further comprising:
if the currently displayed working machine structure is outside a working area, highlighting the working condition data.

6. The dynamic simulation display method for the working machine structure according to any one of claims 1 to 5, wherein the working condition data further comprises: height data of a lifting hook of the working machine and distance data of an arm head from a lifting hook of the working machine to the operating arm, the height data of the lifting hook is determined based on a rope length extended by winch detected by a counting detection device provided on a winch of the working machine and a multiplying ratio, and the distance data of the arm head is determined based on the height data of the lifting hook.

7. The dynamic simulation display method for the working machine structure according to any one of claims 1 to 5, wherein the operating arm comprises a main arm (2) and an auxiliary arm (3); and accordingly,
the working condition data further comprises: angle data of an operating arm corresponding to the main arm (2), angle data of an operating arm corresponding to the auxiliary arm (3), and an included angle between the main arm (2) and the auxiliary arm (3).

8. A dynamic simulation display system for a working machine structure, comprising: a processor (71) and angle sensors (72), wherein the processor (71) is connected to the angle sensors (72), the angle sensors (72) are disposed on a lower arm (22) of an operating arm of a working machine and an upper arm (24) of the operating arm of the working machine; and
the processor (71) is used for executing the dynamic simulation display method for the working machine structure according to any one of claims 1 to 7.

9. The dynamic simulation display system for a working machine structure according to claim 8, further comprising: a counting detection device;
wherein the counting detection device is disposed on a winch of the working machine, and the counting detection device is used for measuring a rope length extended by winch and a multiplying ratio.

## Patentansprüche

1. Ein Verfahren zur dynamischen Simulationsanzeige für eine Arbeitsmaschinenstruktur, das Folgendes beinhaltet:
Erfassen (S1) von Arbeitszustandsdaten einer Arbeitsmaschine in Echtzeit, wobei die Arbeitszustandsdaten Winkeldaten eines Betätigungsarms beinhalten und die Winkeldaten des Betätigungsarms Winkeldaten eines unteren Arms (22) und Winkeldaten eines oberen Arms (24) beinhalten;
dynamisches Aktualisieren (S2) einer aktuell angezeigten Arbeitsmaschinenstruktur gemäß den Arbeitszustandsdaten; und
Vergleichen der Winkeldaten des oberen Arms (24) und der Winkeldaten des unteren Arms (22), um zu bestimmen, ob der Betätigungsarm gebogen und verformt ist;
wobei die Winkeldaten des unteren Arms (22) auf der Basis eines Winkelsensors erhalten werden, der an einem unteren Arm (22) eines Betätigungsarms der Arbeitsmaschine angeordnet ist, und die Winkeldaten des oberen Arms (24) auf der Basis eines Winkelsensors erhalten werden, der an einem oberen Arm (24) des Betätigungsarms der Arbeitsmaschine angeordnet ist.

2. Verfahren zur dynamischen Simulationsanzeige für die Arbeitsmaschinenstruktur gemäß Anspruch 1, wobei die aktuell angezeigte Arbeitsmaschinenstruktur durch Kombinieren von Montagezeichnungen der Arbeitsmaschine auf der Basis von zu einem vorherigen Zeitpunkt erhaltenen Arbeitszustandsdaten der Arbeitsmaschine erhalten wird; und die Montagezeichnungen auf der Basis eines physischen Strukturmodells der Arbeitsmaschine erzeugt werden.

3. Verfahren zur dynamischen Simulationsanzeige für die Arbeitsmaschinenstruktur gemäß Anspruch 1, wobei das Verfahren nach dem Erfassen von Arbeitszustandsdaten einer Arbeitsmaschine in Echtzeit ferner Folgendes beinhaltet:
dynamisches Anzeigen der Arbeitszustandsdaten.

4. Verfahren zur dynamischen Simulationsanzeige für die Arbeitsmaschinenstruktur gemäß Anspruch 3, wobei das dynamische Anzeigen der Arbeitszustandsdaten spezifisch Folgendes beinhaltet:
Anzeigen der Arbeitszustandsdaten in einem Anzeigebereich, der nicht der Anzeigebereich der Arbeitsmaschinenstruktur ist; und/oder
Markieren der Arbeitszustandsdaten an einer entsprechenden Position der Arbeitsmaschinenstruktur.

5. Verfahren zur dynamischen Simulationsanzeige für die Arbeitsmaschinenstruktur gemäß Anspruch 3, das nach dem dynamischen Aktualisieren einer aktuell angezeigten Arbeitsmaschinenstruktur gemäß den Arbeitszustandsdaten ferner Folgendes beinhaltet:
wenn sich die aktuell angezeigte Arbeitsmaschinenstruktur außerhalb eines Arbeitsbereichs befindet, Hervorheben der Arbeitszustandsdaten.

6. Verfahren zur dynamischen Simulationsanzeige für die Arbeitsmaschinenstruktur gemäß einem der Ansprüche 1 bis 5, wobei die Arbeitszustandsdaten ferner Folgendes beinhalten: Höhendaten eines Hebehakens der Arbeitsmaschine und Abstandsdaten eines Armkopfs von einem Hebehaken der Arbeitsmaschine zu dem Betätigungsarm, wobei die Höhendaten des Hebehakens auf der Basis einer durch eine Winde ausgegebenen Seillänge, die durch eine an einer Winde der Arbeitsmaschine bereitgestellte Zähldetektionsvorrichtung detektiert wird, und eines Multiplikationsverhältnisses bestimmt werden und die Abstandsdaten des Armkopfs auf der Basis der Höhendaten des Hebehakens bestimmt werden.

7. Verfahren zur dynamischen Simulationsanzeige für die Arbeitsmaschinenstruktur gemäß einem der Ansprüche 1 bis 5, wobei der Betätigungsarm einen Hauptarm (2) und einen Hilfsarm (3) beinhaltet; und dementsprechend
die Arbeitszustandsdaten ferner Folgendes beinhalten: Winkeldaten eines Betätigungsarms, der dem Hauptarm (2) entspricht, Winkeldaten eines Betätigungsarms, der dem Hilfsarm (3) entspricht, und einen zwischen dem Hauptarm (2) und dem Hilfsarm (3) eingeschlossenen Winkel.

8. Ein System zur dynamischen Simulationsanzeige für eine Arbeitsmaschinenstruktur, das Folgendes beinhaltet: einen Prozessor (71) und Winkelsensoren (72), wobei der Prozessor (71) mit den Winkelsensoren (72) verbunden ist, wobei die Winkelsensoren (72) an einem unteren Arm (22) eines Betätigungsarms einer Arbeitsmaschine und einem oberen Arm (24) des Betätigungsarms der Arbeitsmaschine angeordnet sind; und
der Prozessor (71) zum Ausführen des Verfahrens zur dynamischen Simulationsanzeige für die Arbeitsmaschinenstruktur gemäß einem der Ansprüche 1 bis 7 verwendet wird.

9. System zur dynamischen Simulationsanzeige für eine Arbeitsmaschinenstruktur gemäß Anspruch 8, das ferner Folgendes beinhaltet: eine Zähldetektionsvorrichtung;
wobei die Zähldetektionsvorrichtung an einer Winde der Arbeitsmaschine angeordnet ist und die Zähldetektionsvorrichtung zum Messen einer durch eine Winde ausgegebenen Seillänge und eines Multiplikationsverhältnisses verwendet wird.

## Revendications

1. Un procédé d'affichage de simulation dynamique pour une structure d'engin de chantier, comprenant :
l'acquisition (S1) de données d'état de fonctionnement d'un engin de chantier en temps réel, les données d'état de fonctionnement comprenant des données d'angle d'un bras de manœuvre, et les données d'angle du bras de manœuvre comprenant des données d'angle d'un bras inférieur (22) et des données d'angle d'un bras supérieur (24) ;
la mise à jour (S2) d'une structure d'engin de chantier actuellement affichée de manière dynamique en fonction des données d'état de fonctionnement ; et
la comparaison des données d'angle du bras supérieur (24) et des données d'angle du bras inférieur (22) afin de déterminer si le bras de manœuvre est plié et déformé ;
dans lequel les données d'angle du bras inférieur (22) sont obtenues sur la base d'un capteur d'angle disposé sur un bras inférieur (22) d'un bras de manœuvre de l'engin de chantier, et les données d'angle du bras supérieur (24) sont obtenues sur la base d'un capteur d'angle disposé sur un bras supérieur (24) du bras de manœuvre de l'engin de chantier.

2. Le procédé d'affichage de simulation dynamique pour la structure d'engin de chantier selon la revendication 1, dans lequel la structure d'engin de chantier actuellement affichée est obtenue en combinant des schémas d'ensemble de l'engin de chantier sur la base de données d'état de fonctionnement de l'engin de chantier obtenues à un moment antérieur ; et les schémas d'ensemble sont générés sur la base d'un modèle de structure physique de l'engin de chantier.

3. Le procédé d'affichage de simulation dynamique pour la structure d'engin de chantier selon la revendication 1, après l'acquisition de données d'état de fonctionnement d'un engin de chantier en temps réel, le procédé, comprenant en outre :
l'affichage des données d'état de fonctionnement de manière dynamique.

4. Le procédé d'affichage de simulation dynamique pour la structure d'engin de chantier selon la revendication 3, dans lequel l'affichage des données d'état de fonctionnement de manière dynamique comprend spécifiquement :
l'affichage des données d'état de fonctionnement dans une zone d'affichage qui n'est pas la zone d'affichage de la structure d'engin de chantier ; et/ou
le marquage des données d'état de fonctionnement à une position correspondante de la structure d'engin de chantier.

5. Le procédé d'affichage de simulation dynamique pour la structure d'engin de chantier selon la revendication 3, après la mise à jour d'une structure d'engin de chantier actuellement affichée de manière dynamique en fonction des données d'état de fonctionnement, comprenant en outre :
si la structure d'engin de chantier actuellement affichée est en dehors d'une zone de fonctionnement, la mise en évidence des données d'état de fonctionnement.

6. Le procédé d'affichage de simulation dynamique pour la structure d'engin de chantier selon l'une quelconque des revendications 1 à 5, dans lequel les données d'état de fonctionnement comprennent en outre : des données de hauteur d'un crochet de levage de l'engin de chantier et des données de distance d'une tête de bras depuis un crochet de levage de l'engin de chantier jusqu'au bras de manœuvre, les données de hauteur du crochet de levage sont déterminées sur la base d'une longueur de câble étendue par treuil détectée par un dispositif de détection par comptage prévu sur un treuil de l'engin de chantier et d'un coefficient multiplicateur, et les données de distance de la tête de bras sont déterminées sur la base des données de hauteur du crochet de levage.

7. Le procédé d'affichage de simulation dynamique pour la structure d'engin de chantier selon l'une quelconque des revendications 1 à 5, dans lequel le bras de manœuvre comprend un bras principal (2) et un bras auxiliaire (3) ; et en conséquence,
les données d'état de fonctionnement comprennent en outre : des données d'angle d'un bras de manœuvre correspondant au bras principal (2), des données d'angle d'un bras de manœuvre correspondant au bras auxiliaire (3), et un angle inclus entre le bras principal (2) et le bras auxiliaire (3).

8. Un système d'affichage de simulation dynamique pour une structure d'engin de chantier, comprenant : un processeur (71) et des capteurs d'angle (72), dans lequel le processeur (71) est connecté aux capteurs d'angle (72), les capteurs d'angle (72) sont disposés sur un bras inférieur (22) d'un bras de manœuvre d'un engin de chantier et un bras supérieur (24) du bras de manœuvre de l'engin de chantier ; et
le processeur (71) est utilisé pour exécuter le procédé d'affichage de simulation dynamique pour la structure d'engin de chantier selon l'une quelconque des revendications 1 à 7.

9. Le système d'affichage de simulation dynamique pour une structure d'engin de chantier selon la revendication 8, comprenant en outre : un dispositif de détection par comptage ;
dans lequel le dispositif de détection par comptage est disposé sur un treuil de l'engin de chantier, et le dispositif de détection par comptage est utilisé pour mesurer une longueur de câble étendue par treuil et un coefficient multiplicateur.
